# EUROPEAN PATENT APPLICATION

(11) **EP 4 318 256 A1**
(43) Date of publication of application: **07.02.2024**
(21) Application number: 23186635.1
(22) Date of filing: 20.07.2023
(51) Int. Cl.: G06F 15/78

(54) **RELAY REFLASH DETECTION AND PROPAGATION IN A BOOLEAN RELAY LOGIC ON A FPGA RELAY SYSTEM**

(30) Priority: 03.08.2022 IN 202211044374
(71) Applicant: Baker Hughes Holdings LLC, Houston, TX 77073 (US)
(72) Inventor: GORE, Saurabh, 400081 Mumbai (IN); SONAVANE, Sagar, 400022 Mumbai (IN)
(74) Representative: Illingworth-Law, William Illingworth

(57) **Abstract**

A relay logic evaluator includes circuitry configured to receive signals indicative of a status change. The circuitry is configured to send a second signal indicative of the status changes received by the circuitry. A controller is coupled to the relay logic evaluator. The controller is configured to determine a value indicative of a count of status changes responsive to receiving the second signal from the circuitry. The controller is configured to provide a signal indicative of the value.

## Description

### TECHNICAL FIELD

This disclosure relates to reflash detection in performance monitoring systems.

### BACKGROUND

A field-programmable gate array (FPGA) is an integrated circuit designed to be configured by a customer or a designer after manufacturing. The FPGA configuration is generally specified using a hardware description language (HDL). FPGAs contain an array of programmable logic blocks, and a hierarchy of reconfigurable interconnects allowing blocks to be wired together. Logic blocks can be configured to perform complex combinational functions, or act as simple logic gates like AND and XOR. In most FPGAs, logic blocks also include memory elements, which may be simple flip-flops or more complete blocks of memory. Many FPGAs can be reprogrammed to implement different logic functions, allowing flexible reconfigurable computing as performed in computer software. Such systems are sometimes deployed in plant monitoring systems.

### SUMMARY

The subject matter describe in this disclosure relates to relay reflash detection and propagation in a boolean relay logic on a Field Programmable Gate Array (FPGA).

An example implementation of the subject matter is a relay system with the following system. A relay logic evaluator includes circuitry configured to receive signals indicative of a status change. The circuitry is configured to send a second signal indicative of the status changes received by the circuitry. A controller is coupled to the relay logic evaluator. The controller is configured to determine a value indicative of a count of status changes responsive to receiving the second signal from the circuitry. The controller is configured to provide a signal indicative of the value.

Aspects of the example relay system, which can be combined with the example relay system alone or in combination with other aspects, include the following. The controller includes a reflash queue counter configured to receive the second signal and determine the value indicative of a count of status changes responsive to receiving the second signal from the circuitry of the relay logic evaluator. A relay output controller is configured to provide the signal indicative of the value.

Aspects of the example relay system, which can be combined with the example relay system alone or in combination with other aspects, include the following. Input configuration pins are configured to receive configuration signals configured to adjust settings of the controller.

Aspects of the example relay system, which can be combined with the example relay system alone or in combination with other aspects, include the following. The signal indicative of the value comprises a square wave signal.

Aspects of the example relay system, which can be combined with the example relay system alone or in combination with other aspects, include the following. A light is coupled to the controller.

Aspects of the example relay system, which can be combined with the example relay system alone or in combination with other aspects, include the following. The light is configured to flash at a rate wherein a count of flashes is discernable by a human observer.

Aspects of the example relay system, which can be combined with the example relay system alone or in combination with other aspects, include the following. The relay logic evaluator includes multiple inputs. The relay logic evaluator is configured to receive multiple signals sequentially by the inputs.

Aspects of the example relay system, which can be combined with the example relay system alone or in combination with other aspects, include the following. The relay logic evaluator comprises up to 255 inputs.

Aspects of the example relay system, which can be combined with the example relay system alone or in combination with other aspects, include the following. The signal indicative of a status change originates from a sensor outputting a signal that exceeds a threshold value. The sensor operates within a plant.

An example implementation of the subject matter described within this disclosure is a method with the following features. A signal indicative of a status change is received by logic evaluator circuitry. A value indicative of a number of status changes is determined by a controller based on the received signal. A signal indicative of the determined value is provided by the controller.

Aspects of the example method, which can be combined with the example method alone or in combination with other aspects, include the following. The signal is received by a light configured to flash a sequence of flashes equal to the determined value responsive to receiving the signal.

Aspects of the example method, which can be combined with the example method alone or in combination with other aspects, include the following. The light flashes at a rate discernable to a human observer.

Aspects of the example method, which can be combined with the example method alone or in combination with other aspects, include the following. The controller includes configuration pins. The method further includes configuring, by configuration pins, the controller.

Aspects of the example method, which can be combined with the example method alone or in combination with other aspects, include the following. Configuring the controller includes adjusting an allowable queue length, adjusting a reflash time, or changing a reflash enablement state.

An example implementation of the subject matter described within this disclosure is a relay system with the following features. A relay logic evaluator includes circuits configured to receive signals indicative of a status change. The circuits are configured to send a second signal indicative of the status changes received by the relay logic evaluator. A controller is coupled to the relay logic evaluator. The controller is configured to determine a value indicative of a count of status changes responsive to receiving the second signal from the circuits of the relay logic evaluator. The controller is configured to provide a signal indicative of the value. The controller includes a processor and a non-transitory memory containing instructions instructing the processor to perform the following operations. A value indicative of a number of status changes is determined by the controller based on a received signal. A signal indicative of the determined value is provided by the controller.

Aspects of the example relay system, which can be combined with the example relay system alone or in combination with other aspects, include the following. The controller includes a reflash queue counter configured to receive the second signal and determine the value indicative of a count of status changes responsive to receiving the second signal from the circuits of relay logic evaluator. A relay output controller is configured to provide the signal indicative of the value.

Aspects of the example relay system, which can be combined with the example relay system alone or in combination with other aspects, include the following. Input configuration pins are configured to receive configuration signals configured to adjust settings of the controller.

Aspects of the example relay system, which can be combined with the example relay system alone or in combination with other aspects, include the following. A light is coupled to the controller.

Aspects of the example relay system, which can be combined with the example relay system alone or in combination with other aspects, include the following. The light is configured to flash at a rate wherein a count of flashes is discernable by a human observer.

Aspects of the example relay system, which can be combined with the example relay system alone or in combination with other aspects, include the following. The relay logic evaluator includes multiple inputs. The relay logic evaluator is configured to receive multiple signals simultaneously by the plurality of inputs.

The details of one or more implementations of the disclosure are set forth in the accompanying drawings and description below. Other features, objects, and advantages of the disclosure are apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIG. 1 illustrates a block diagram of an example relay system.
FIG. 2 illustrates a block diagram of an example controller that can be used with aspects of this disclosure.
FIG. 3 illustrates a flowchart of an example method that can be used with aspects of this disclosure.

Like reference numbers shown in various figures refer to similar features.

### DETAILED DESCRIPTION

This disclosure relates to relay reflash detection and propagation in a Boolean relay logic on a Field Programable Field Array (FPGA). More specifically, re-flash detection and propagation are integrated into the relay logic rule engine for processing reflash, and Hardware Description Language (HDL) is used for describing the structure and behavior of the logic circuit. The relay reflash detection, processing, and propagation can be performed by the subject matter described herein. Each input is continuously (e.g., at a sufficient sample rate to detect an anticipated signal) to monitor for an alarm transition for 0-1, and any number of inputs can be monitored. The concepts described herein can be used to detect and register transitions at every processing input step (i.e. when the transition that propagates throughout relay logic towards the output relay detected). Detected transitions are propagated throughout the relay logic. The propagation of re-flash from input to output contains boolean logic between input and output. Finally apply to the output relay based on the input reflash detected the output of relay in which re-flash is enabled that particular relay is reflash. If x number of the reflash sequence is detected at input then the output relay is reflash x number of times. Hence, this circuit eliminates the external hardware for processing or detecting or propagating reflash.

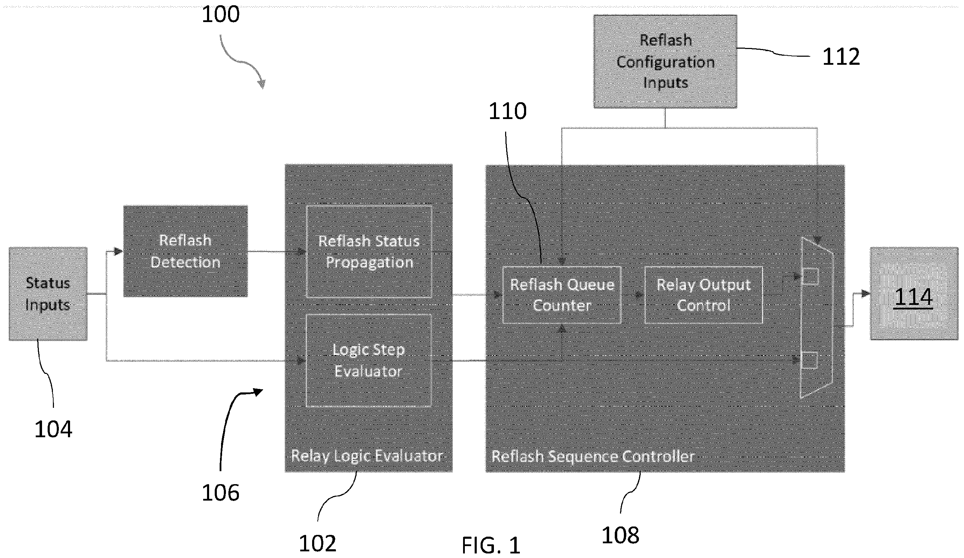

FIG. 1 illustrates a block diagram of an example relay system 100. The relay system 100 includes the relay logic evaluator 102. The relay logic evaluator 102 includes a plurality of inputs 104. In some implementations, the relay logic evaluator 102 is configured to receive multiple signals sequentially by the plurality of inputs 104. In some implementations, the relay logic evaluator 102 is configured to receive multiple signals simultaneously by the plurality of inputs 104. In some implementations, the relay logic evaluator includes up to 255 inputs. In some implementations, the signals indicative of a status change originate from a sensors outputting a signal that exceeds a threshold value. Such sensors can operate, for example, within a plant (power plant, processing plant, gas plant, production facility, etc.). In some implementations, the signals indicative of a status change originate or are conditioned by a separate controller or conditioning system. For example, the signal may be received from a sensor by a control room where threshold values (such as alarm values) are set. Once the sensor signal is indicative of exceeding a pre-set value, the control room may send a signal to the relay logic evaluator.

The relay logic evaluator 102 comprising circuitry 106 configured to receive signals indicative of a status change, such as a detected reflash of a status. Such statuses can include crossing a specified threshold value, on/off transitions, trip indicators and/or alarm indicators. The circuitry is configured to send a second signal, indicative of the status changes received by the circuitry, to the controller 108.

The controller 108 is coupled to the relay logic evaluator 102, such as by a wired or wireless data connection. In some implementations, the controller 108 and the relay logic evaluator 102 reside on the same processing system for example, on the same FPGA. The controller 108 is configured to determine a value indicative of a count of status changes responsive to receiving the second signal from the circuitry 106. That is, the controller counts the number of status changes detected by the relay logic evaluator 102. The controller 108 is configured to provide a signal indicative of the count value. In some implementations, the controller 108 includes a reflash queue counter 110 configured to receive the second signal and determine the value indicative of a count of status changes responsive to receiving the second signal from the circuitry of the relay logic evaluator 102. That is, in such implementations, the reflash queue counter 110 determines a count based on the signal from the relay logic evaluator 102. Once a count value has been determined, a relay output controller 108, coupled to the reflash queue counter 110, is configured to provide the signal indicative of the value. Such a signal can include a square wave signal, a sine wave signal, or any other electrical signal appropriate for communicating such a value.

In some implementations, the controller 108 includes input configuration pins configured to receive configuration signals configured to adjust settings of the controller 108. Such settings can include allowable queue length, reflash timing, and/or a reflash enablement state. Such settings are discussed throughout this disclosure. In some implementations, the configuration pins include soft inputs in the form of FPGA registers or memory. In some implementations, the configuration pins include hard pins that are accessible from an enclosure in which the controller 108 resides.

In some implementations, a light 114 is coupled to the controller. In such an implementation, the light 114 receives the signal indicative of the count value, and flashes a sequence equal to the count value. The light 114 is configured to flash at a rate wherein a count of flashes is discernable by a human observer, for example, at a rate of one flash per second. In some implementations, the flash rate is a setting that can be adjusted by the input configuration pins. While primarily described as being coupled to a light, other components can be coupled to the controller 108 without departing from this disclosure, for example, a data recorder or a display that interprets the count value to display the value as a numer.

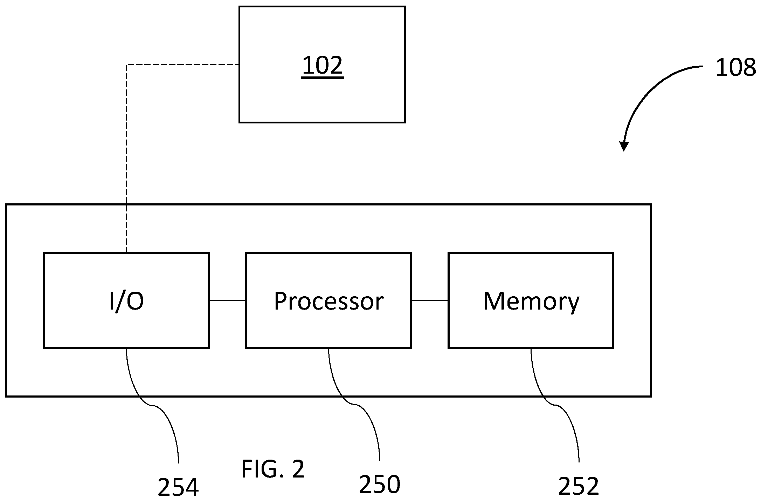

FIG. 2 is a block diagram of an example controller 108 that can be used with aspects of this disclosure. The controller 108 can, among other things, monitor parameters of the system 100 and send signals to actuate and/or adjust various operating parameters of the system. As shown in FIG. 4, the controller 108 can include one or more processors 250 and non-transitory storage media (e.g., memory 252) containing instructions that cause the processors 250 to perform operations described herein. The processors 250 are coupled to an input/output (I/O) interface 254 for sending and receiving communications with components in the system, including, for example, the evaluator 102. In certain instances, the controller 108 can additionally communicate status with and send actuation and/or control signals to one or more of the various system components (including systems within a plant coupled to the system) of the system 100, as well as other sensors (e.g., pressure sensors, temperature sensors, vibration sensors and other types of sensors) that provide signals to the system 100. While illustrated in FIG. 2 as being within the controller, various controller components, such as the processor 205 and/or memory 252, can be located separately from the controller without departing from this disclosure.

In some implementations, the memory 252 contains instructions instructing the processor to perform various operations. For example, in some implementations, the instructions instruct the processor 250 to determine a value indicative of a number of status changes based on a received signal. In some implementations, the instructions instruct the processor 250 to provide a signal, indicative of the determined value.

In operation alarm inputs to the system are scanned periodically. For every alarm input, if a transition is detected from "No Alarm" state to "Alarm state", a reflash status bit is set and stored in memory 252 for the corresponding alarm input. In some implementations, every operator step in the rule logic is evaluated sequentially. In some implementations, every operator step in the rule logic is evaluated simultaneiously.

During Operator evaluation, if any of the input to the operator step has its reflash status set. The reflash status for the output of the operator step is also set and stored in the memory 252. Every relay output step in the rule logic is evaluated sequentially. If any of the input to the relay output step has its reflash status set, the counter 110 is incremented for the corresponding relay output and stored in the memory 252; however, if the counter 110 reaches the configured queue length (set by the configuration pins 112 in FIG. 1), then the counter 110 is no longer incremented.

In instances where the reflash option is enabled for the relay output (for example, by the configuration pins 112 in FIG. 1), and the reflash counter is greater than zero, the relay output is reflashed, that is, a relay is un-tripped for the configured reflash duration and tripped again for the configured reflash duration. For every reflash sequence, the counter is decremented by one. In some implementations, a light can be coupled to this process to flash a sequence indicative of the total count.

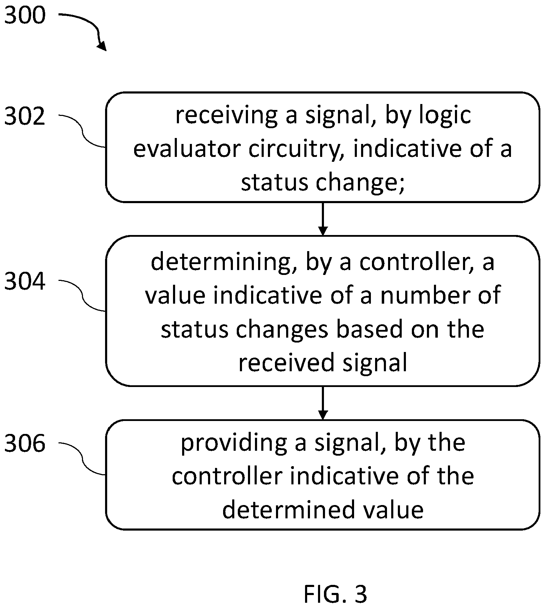

FIG. 3 illustrates a flowchart of an example method 300 that can be used with aspects of this disclosure. In some implementations, all or part of the method steps are performed by the controller 108. At 302, a signal is received by logic evaluator circuitry. The signal is indicative of a status change. Examples of such status changes are described throughout this disclosure.

At 304, a value indicative of a number of status changes is determined, for example, by the controller 108, based on the received signal. At 306, a signal indicative of the determined value is provided by the controller 108. In some implementations, the signal is received by a light 114 (FIG. 1) configured to flash a sequence of flashes equal to the determined value responsive to receiving the signal. For example, five status changes result in five flashes. In such an implementation, the light flashes at a rate discernable to a human observer, for example, one flash per second.

In some implementations, the controller is configurable by configuration pins. For example, the configuration pins receive an electrical signal to configure the controller. Such configuration signals can be used to, for example, adjust an allowable queue length. Such an adjustment is used to determine a maximum number of events that can be processed by the controller, for example, 255 events can be set as the maximum. Alternatively or in addition, a reflash time can be adjusted. Alternatively or in addition, a reflash enablement state can be toggled, for example, into an "on" state or an "off state".

While this disclosure contains many specific implementation details, these should not be construed as limitations on the scope of what may be claimed, but rather as descriptions of features specific to particular implementations of particular inventions. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. Moreover, the separation of various system components in the implementations described above should not be understood as requiring such separation in all implementations, and it should be understood that the described components and systems can generally be integrated together in a single product or packaged into multiple products.

Thus, particular implementations of the subject matter have been described. Other implementations are within the scope of the following claims. In some cases, the actions recited in the claims can be performed in a different order and still achieve desirable results. In addition, the processes depicted in the accompanying figures do not necessarily require the particular order shown, or sequential order, to achieve desirable results.

## Claims

1. A relay system comprising:
a relay logic evaluator comprising circuitry configured to receive signals indicative of a status change, the circuitry configured to send a second signal indicative of the status changes received by the circuitry; and
a controller coupled to the relay logic evaluator, the controller configured to determine a value indicative of a count of status changes responsive to receiving the second signal from the circuitry, the controller configured to provide a signal indicative of the value.

2. The relay system of claim 1, wherein the controller comprises:
a reflash queue counter configured to receive the second signal and determine the value indicative of a count of status changes responsive to receiving the second signal from the circuitry of the relay logic evaluator; and
a relay output controller configured to provide the signal indicative of the value.

3. The relay system of claim 1, further comprising input configuration pins configured to receive configuration signals configured to adjust settings of the controller.

4. The relay system of claim 1, wherein the signal indicative of the value comprises a square wave signal.

5. The relay system of claim 1, further comprising a light coupled to the controller.

6. The relay system of claim 5, wherein the light is configured to flash at a rate wherein a count of flashes is discernable by a human observer.

7. The relay system of claim 1, wherein the relay logic evaluator comprises a plurality of inputs, the relay logic evaluator configured to receive multiple signals sequentially by the plurality of inputs.

8. The relay system of claim 7, wherein the relay logic evaluator comprises up to 255 inputs.

9. The system of claim 7, wherein the signal indicative of a status change originates from a sensor outputting a signal that exceeds a threshold value, the sensor operating within a plant.

10. A method comprising:
receiving a signal, by logic evaluator circuitry, indicative of a status change;
determining, by a controller, a value indicative of a number of status changes based on the received signal; and
providing a signal, by the controller indicative of the determined value.

11. The method of claim 10, further comprising receiving the signal by a light configured to flash a sequence of flashes equal to the determined value responsive to receiving the signal.

12. The method of claim 11, wherein the light flashes at a rate discernable to a human observer.

13. The method of claim 10, wherein the controller comprises configuration pins, the method further comprising:
configuring, by configuration pins, the controller.

14. The method of claim 13, wherein configuring the controller comprises:
adjusting an allowable queue length;
adjusting a reflash time; or
changing a reflash enablement state.

15. A relay system comprising:
a relay logic evaluator comprising circuits configured to receive signals indicative of a status change, the circuits configured to send a second signal indicative of the status changes received by the relay logic evaluator;
a controller coupled to the relay logic evaluator, the controller configured to determine a value indicative of a count of status changes responsive to receiving the second signal from the circuits of the relay logic evaluator, the controller configured to provide a signal indicative of the value, the controller comprising:
a processor; and
a non-transitory memory containing instructions instructing the processor to:
determine, by the controller, a value indicative of a number of status changes based on a received signal; and
provide a signal, by the controller indicative of the determined value.

16. The relay system of claim 15, wherein the controller comprises:
a reflash queue counter configured to receive the second signal and determine the value indicative of a count of status changes responsive to receiving the second signal from the circuits of relay logic evaluator; and
a relay output controller configured to provide the signal indicative of the value.

17. The relay system of claim 15, further comprising input configuration pins configured to receive configuration signals configured to adjust settings of the controller.

18. The relay system of claim 15, further comprising a light coupled to the controller.

19. The relay system of claim 18, wherein the light is configured to flash at a rate wherein a count of flashes is discernable by a human observer.

20. The relay system of claim 15, wherein the relay logic evaluator comprises a plurality of inputs, the relay logic evaluator configured to receive multiple signals simultaneously by the plurality of inputs.
